# EUROPÄISCHE PATENTSCHRIFT

(11) **EP 0 389 506 B1**
(45) Veröffentlichungstag und Bekanntmachung des Hinweises auf die Patenterteilung: **06.04.1994**
(21) Anmeldenummer: 88909321.7
(22) Anmeldetag: 02.11.1988
(51) Int. Cl.: C23C 14/34, H01J 37/317

(54) **VERFAHREN ZUM ERZEUGEN DÜNNER SCHICHTEN AUS HOCHSCHMELZENDEM ODER BEI HOHER TEMPERATUR SUBLIMIERENDEM MATERIAL WELCHES AUS UNTERSCHIEDLICHEN CHEMISCHEN VERBINDUNGEN ZUSAMMENGESETZT IST AUF EINEM SUBSTRAT**
PROCESS FOR PRODUCING THIN LAYERS OF A MATERIAL COMPOSED OF DIFFERENT CHEMICAL COMPOUNDS WHICH MELTS OR SUBLIMES AT HIGH TEMPERATURES ON A SUBSTRATE
PROCEDE POUR PRODUIRE SUR UN SUBSTRAT DES COUCHES MINCES A PARTIR D'UN MATERIAU SE COMPOSANT DE COMPOSES CHIMIQUES DIFFERENTS A POINT DE FUSION ELEVE OU A SUBLIMATION A HAUTE TEMPERATURE

(30) Priorität: 02.11.1987 DE 3737142
(43) Veröffentlichungstag der Anmeldung: 03.10.1990
(73) Patentinhaber: CHRISTIANSEN, Jens, D-91054 Buckenhof (DE); FRANK, Klaus, D-91341 Röttenbach (DE)
(72) Erfinder: CHRISTIANSEN, Jens, D-91054 Buckenhof (DE); FRANK, Klaus, D-91341 Röttenbach (DE)
(74) Vertreter: Twelmeier, Ulrich, Dipl.Phys.
(86) Internationale Anmeldenummer: EP8800992
(87) Internationale Veröffentlichungsnummer: WO8904382

(56) Entgegenhaltungen:
- EP-A- 0 019 725
- CH-A- 454 566
- DE-A- 1 521 327
- US-A- 3 408 283
- US-A- 3 925 187
- HANDBOOK OF THIN FILM TECHNOLOGY, L.I.MAISSEL und R.GLANG (Hrsg.),McGraw-Hill,US,1970; Kapitel I,Sektion 4d(2), Seiten 1-52 und 1-53: "Self-accelerated Electron Guns"
- SOLID STATE TECHNOLOGY, September 1989, Seiten 141-146; R.SIMON: "High-Temperature Superconductors for Microelectronics"

## Beschreibung

Die Erfindung befaßt sich mit der Erzeugung dünner Schichten aus hochschmelzendem oder bei hoher Temperatur sublimierendem Material, welches aus unterschiedlichen chemischen Komponenten zusammengesetzt ist, auf einem Substrat, insbesondere mit der Erzeugung supraleitender Schichten aus keramischem Material. Ausserdem befaßt sich die Erfindung mit der Verwendung einer Vorrichtung, mit deren Hilfe solche Schichten erzeugt werden können.

Der künftige technische Einsatz von keramischen Hochtemperatursupraleitern, welche von Bednorz und Müller entdeckt wurden, hängt entscheidend davon ab, wie es gelingt, diese keramischen Supraleiter in Gestalt von möglichst einkristallinen Schichten auf Substraten abzuscheiden. Als Abscheideverfahren hat man dazu bislang z.B. die Molekularstrahlepitaxie, das Sputtern und das Laserverdampfen angewendet (Z. "News in Optronics and Lasers" vom 23. Sept. 1987). Am vielversprechendsten war bisher der Einsatz von Eximer-Lasern. Eximer-Laser sind deshalb geeignet, weil sie mit Energien von 1 bis 4 Joule pro Schuß bei einem Brennfleck, der nicht mehr als 3 mm Durchmesser hat, hinreichend viel Energie in einem keramischen Target deponieren können, um dessen Komponenten zu verdampfen und im richtigen stöchiometrischen Verhältnis auf einem Substrat niederzuschlagen. Die so hergestellten Schichten sind meistens amorph und werden einer Temperaturbehandlung, insbesondere unter Sauerstoff, unterzogen, um die richtige supraleitende Phase einkristallin zu erzeugen. Nachteilig dabei ist, dass das Laserverdampfen ein ausserordentlich aufwendiges Verfahren ist. Allein die Anschaffungskosten für einen geeigneten Hochleistungs-Eximer-Laser betragen ungefähr DM 800.000,--.

Der Erfindung liegt deshalb die Aufgabe zugrunde, ein Verfahren und eine Vorrichtung verfügbar zu machen, mit welchen sich keramische Hochtemperatur-Supraleiter mit geringerem Aufwand in Form dünner Schichten abscheiden lassen.

Andererseits ist es aus der DE-28 04 393 C2 bekannt, dass man mit einem gepulsten Elektronenstrahl, welcher eine Pseudofunkenentladung begleitet, Materialen bzw. Metalle, auf die der Elektronenstrahl auftrifft, zum Verdampfen bringen bzw. bohren kann.

Nach der Offenbarung in der DE-28 04 393 C2 können Pseudofunkenentladungen in einem Entladungsgefäß erzeugt werden, das im Abstand voneinander angeordnete Metallelektroden aufweist, die durch eine sie umgebende isolierende Wand gehalten sind und einen Gasentladungskanal aufweisen, der von fluchtenden Öffnungen in den Elektroden gebildet wird. In dieses Entladungsgefäß wird eine ionisierbare Niederdruck-Gasfüllung eingebracht, deren Druck nach der Lehre der DE-28 04 393 C2 so bemessen ist, dass das Produkt aus dem Elektrodenabstand (d) und im Gasdruck (p) in der Größenordnung von 130 Pascal · mm oder weniger beträgt. Die schnelle funkenähnliche Gasentladung, die sich ergibt, wenn eine solche Anordnung getriggert wird, oder die sich spontan ergibt, sobald die Durchbruchsspannung überschritten wird, ist in der Literatur seit 1979 als Pseudofunken-Gasentladung bekannt. Sie tritt in Erweiterung des in der DE-28 04 393 C2 festgelegten p·d-Bereiches bei Werten von p·d auf, die eine fallende Zündspannungs-Druckcharakteristik bei steigendem Druck aufweisen. Dieser Druckbereich entspricht in der für planparallele Elektroden üblichen Kennzeichnung dem "Durchbruch einer Gasentladung am linken Ast der Paschen-Kurve", wobei der linke Ast anschließt an das Minimum in der Kennlinie, die die Durchbruchsspannung als Funktion von p·d beschreibt. Im Rahmen dieser Patentschrift wollen wir unter Pseudofunken alle Gasentladungen verstehen, die bei Drücken spontan zünden, die kleiner sind als jener Druck, der das Minimum in der Gasdruck-Zündspannungs-Kennlinie des Systems beschreibt. Untersuchungen an Pseudofunkenkammern wurden bisher fast ausschließlich für wissenschaftliche Zwecke durchgeführt. Eine technische Anwendung zur Herstellung eines schnellen gaselektronischen Schalters ist in der älteren, aber nicht vorveröffentlichten Patentanmeldung PCT/EP88/00 574 offenbart. Darin findet sich eine Gasentladungskammer, in welcher zwischen der Kathode und der Anode noch weitere Elektroden angeordnet sind, die alle mit fluchtenden Bohrungen versehen sind. Zu dem die Pseudofunkenentladung begleitenden Elektronenstrahl werden Ströme bis zu mehreren 100 A (im Grenzfall mehrere kA) beobachtet, die während einer Zeitdauer in der Größenordnung von 10⁻⁸ s, typisch für Zeitdauern von 3.10⁻⁹ bis 10⁻⁷ s auftreten. Beim gaselektronischen Schalter ist die materialabtragende Wirkung des Elektronenstrahls eine unerwünschte Begleiterscheinung, weshalb die Anode dort durchbohrt ist, damit der Elektronenstrahl sie nicht erodiert. Hinter der Anode trifft der Elektronenstrahl auf eine Kammerwand, die mit einem Hartmetall bestückt ist, um sie besonders widerstandfähig zu machen.

Die der Erfindung zugrundeliegende Aufgabe wird gelöst durch ein Verfahren mit den im Anspruch 1 angegebenen Merkmalen und durch die Verwendung einer Vorrichtung mit den im Anspruch 21 angegebenen Merkmalen. Vorteilhafte Weiterbildungen der Erfindung sind Gegenstand der Unteransprüche.

Es ist ein wesentlicher Vorteil der Erfindung, daß mit dem gepulsten Elektronenstrahl, welcher Pseudofunkenentladungen begleitet, in einem Target - bezogen auf die Auftreffläche des Strahls - Energien deponiert werden können, die höher sind als die Energien, die z.Zt. mit UV-Licht aus Eximer-Lasern bei gleicher Auftreffläche deponiert werden können. Inzwischen weiß man, dass es dafür verschiedene Gründe gibt. Zum einen hat der die Pseudofunkenentladung begleitende Elektronenstrahl - anders als ein Elektronenstrahl im Hochvakuum - die Eigenschaft, dass mit seiner Ausbreitung um ihm herum ein Plasma entsteht, welches eine verhältnismässig hohe Leitfähigkeit aufweist.
Das hat im vorliegenden Fall den Vorteil, dass der Elektronenstrahl beim Auftreffen auf ein Target aus isoliertem Material keine wesentliche Aufladung des Targets bewirkt, so dass es möglich ist, im Auftreffbereich des Elektronenstrahl einen erheblichen Teil der im Elektronenstrahl enthaltenen Energie (sie beträgt typisch 1/100 bis 1 Joule pro Entladung) auf engstem Raum zu deponieren. Die den Elektronenstrahl umgebende Raumladungshülle schnürt den Elektronenstrahl auf Raumgebiete in der Größenordnung von 1/100.000 cm² bis zu 1/10 cm² ein und bewirkt, dass bei Zündspannungen von 20 kV bis 100 kV und einer Stromstärke in Elektronenstrahl von einigen 100 A in der Auftreffzone ein äußerst dichtes, sehr heißes Plasma erzeugt wird, welches die Bestandteile des Targets enthält. So konnten beim Beschießen eines Kupfer-Targets mit einem Schuß mehr als 10¹⁷ Atome verdampft werden. Ferner wirkt sich vorteilhaft aus, dass von dem auf das Target auftreffenden Elektronenstrahl ein viel kleinerer Anteil reflektiert wird als von einem UV-Lichtstrahl aus einem Eximer-Laser. Um - bezogen auf dieselbe Auftreffläche - dieselbe Energie im Target zu deponieren wie mit einem Elektronenstrahl benötigt man bei einem Eximer-Laser größenordnungsmässig eine 50 x höhere Energie. Der Vorteil der Erfindung besteht aber nicht nur darin, dass man eine höhere Energiedeponierung im Target schafft, ein entscheidender Vorteil liegt vielmehr darin, dass das mit ausserordentlich geringem Aufwand möglich ist, nämlich mit einer Pseudofunken-Entladungskammer, die im Aufbau sehr einfach ist, nur ungefähr faustgroß sein muss und deren Anschaffungpreis verglichen mit dem Anschaffungspreis eines Eximer-Lasers vernachlässigbar niedrig ist. Angesichts der ausserordentlich niedrigen Anschaffungskosten spielen die Lebensdauer, Wartung, Verfügbarkeit und Ersatzbeschaffung im Gegensatz zur Verwendung eines Eximer-Lasers praktisch keine Rolle. Deshalb ist es erfindungsgemäß ohne weiteres möglich, dass man großflächige Beschichtungen herstellt, indem man ein entsprechend großflächiges Substrat mit Hilfe einer Reihenanordnung oder einer zweidimensionalen Anordnung aus einer größeren Anzahl von Pseudofunkenkammern beschichtet.

Das erfindungsgemäße Verfahren eignet sich besonders für die Abscheidung dünner Schichten von keramischen Hochtemperatursupraleitern, insbesondere des Supraleiters Y₁ Ba₂ Cu₃ O₇ mit einer Sprungtemperatur von 92 K. Dazu geht man von einem gesinterten Target aus, welches das supraleitende Material in seiner für die Supraleitung nötigen stöchiometrischen Zusammensetzung enthält. Die besten Ergebnisse erzielt man, wenn man das Target in einer Atmosphäre beschießt, welche einen Sauerstoffanteil hat, und wenn man das Substrat während des Beschichtungsvorganges beheizt, beim Supraleiter Y₁ Ba₂ Cu₃ O₇ auf eine Temperatur von 880°C oder etwas darüber. Die Beheizung begünstigt das Einbinden des stöchiometrisch erforderlichen Sauerstoffanteils in der auf dem Substrat abgeschiedenen Schicht und das Ausbilden einer einkristallinen Struktur der Schicht, welche wichtig ist, um unterhalb der Sprungtemperatur einen möglichst niedrigen elektrischen Widerstand der Schicht zu erzielen. In anderen Fällen kann das Substrat auch gekühlt werden. Wenn nötig, kann die abgeschiedene Schicht einer Nachbehandlung unterzogen werden, um ihre Struktur und/oder Zusammensetzung zu optimieren. Als Nachbehandlung kommt insbesondere eine Wärmebehandlung in sauerstoffhaltiger Atmosphäre in Betracht, um ein Sauerstoffdefizit in der Schicht auszugleichen. Darüberhinaus kommen auch physikalische und chemische Nachbehandlungen in Frage, z.B. in der Weise, dass man die Schicht in inerter oder in reaktiver Atmosphäre einem Plasma aussetzt (Plasma-CVD-Verfahren, PVD-Verfahren und dergleichen mehr), oder mit einem Pseudofunken - Elektronenstrahl behandelt.

Durch den auftreffenden Elektronenstrahl wird das Target zu einem kleinen Teil verdampft. Die bei der Verdampfung auftretende hohe Temperatur führt zu einer plasmaähnlichen bzw. zu einer Plasmaeigenschaft des Materialdampfes, der sich ausgehend von seinem Entstehungsort explosionsartig ausdehnt und auf dem Substrat niederschlägt. Naturgemäß wird das Niederschlagen nicht gleichmässig auf der gesamten Substratoberfläche erfolgen. Deshalb wird bevorzugt, dass man das Substrat während des Beschichtungsvorganges bewegt. Ausserdem läßt man vorzugsweise auch den Brennfleck des Elektronenstrahls über das Target wandern, damit dieses gleichmässig abbrennt und durch ungleichmässige Kondensation von verdampften Bestandteilen des Targets auf dem Target dessen anfänglich homogene Zusammensetzung nicht geändert wird.

Das erfindungsgemäße Verfahren eignet sich nicht nur für das Abscheiden keramischer Supraleiter, sondern auch für die Abscheidung anderer hochschmelzender oder bei hoher Temperatur sublimierender Materialien, bei denen es sich nicht nur um elektrisch nichtleitende keramische oder Oxidwerkstoffe handeln muss, sondern bei denen es sich auch um halbleitende oder leitende Materialien handeln kann.

Die nach dem erfindungsgemäßen Verfahren erzeugten Schichten zeichnen sich durch besondere Festigkeit und Einhaltung der stöchiometrischen Vorgabe bei Gemischen aus, was eine Folge der extrem hohen Temperaturen beim Entstehungsprozess ist. Vorzugsweise stellt man nach dem erfindungsgemäßen Verfahren Schichten her, welche bis zu einigen µm dick sind.

Arbeitet man mit mehreren Elektronenstrahlen nebeneinander, die auf ein oder mehrere Targets auftreffen, so kann man dadurch nicht nur großflächigere Beschichtungen herstellen, sondern auch Beschichtungen, die planmässig aus unterschiedlichen chemischen Komponenten zusammengesetzt wird, die eine chemische Verbindung, einen Verbundwerkstoff oder eine Legierung bilden.

Die Zusammensetzung des Plasmas, welches entsteht, wenn der pulsierende Elektronenstrahl auf das Target auftrifft, kann durch Veränderung der Energieverteilung der Elektronen im Elektronenstrahl beeinflußt werden. Die Energieverteilung der Elektronen ihrerseits kann durch Variation der physikalischen Bedingungen, unter denen die Pseudofunkenentladung stattfindet (in erster Linie durch Änderung des Gasdrucks und der Zündspannung) beeinflußt werden, sowie auch dadurch, dass aus dem entstehenden Elektronenstrahl Teilbereiche ausgeblendet werden.

Als Gas, in welchem die Pseudofunkenentladung stattfindet, kommen vor allem Inertgase, beispielsweise Argon, infrage. Energetisch besonders günstig ist Helium. Je nach dem abzuscheidenen Material kann dem Inertgas ein Reaktivgas beigemischt werden. Für die Abscheidung oxidkeramischer Werkstoffe kann dem Inertgas als Reaktivgas Sauerstoff beigemischt werden, nicht jedoch Wasserstoff, welcher als Füllgas besonders geeignet ist, wenn die Pseudofunkenkammer, als gaselektronischer Schalter verwendet werden soll (PCT/EP88/00574).

Die Verwendung einer zur Durchführung des erfindungsgemäßen Verfahrens geeigneten Vorrichtung ist Gegenstand des Anspruchs 21. Um in dieser Vorrichtung ein Substrat zu beschichten, wird das Gehäuse geöffnet, das Substrat an einer dafür vorgesehenen ersten Halterung und das Target, mit dessen Material das Substrat beschichtet werden soll, an einer dafür vorgesehenen zweiten Halterung befestigt. Danach wird das Gehäuse dicht verschlossen, abgepumpt, durch kontrolliere Zufuhr eines Inertgases und ggfs. eines Reaktivgases eine Niederdruckatmosphäre mit vorgegebener Zusammensetzung und vorgegebenem Druck eingestellt, und danach werden wiederholt (typisch mit einer Wiederholfrequenz von einigen kHz) Pseudofunkenentladungen gezündet, bis sich auf dem Substrat eine Schicht mit der gewünschten Dicke gebildet hat. Das Target befindet sich vorzugsweise dicht hinter dem Loch in der Anode, wo es am intensivsten von dem pulsierenden Elektronenstrahl getroffen wird. Es ist aber auch möglich, das Target nicht in der Flucht der Löcher in Anode und Kathode anzuordnen, sondern seitlich davon, und die Elektronen durch ein besonderes Magnetfeld auf das Target zu leiten. Durch ein veränderliches Magnetfeld kann der Elektronenstrahl auch über eine größere Fläche des Targets hinwegbewegt werden, so dass dieses gleichmässig abdampft. Hierin liegt ein weiterer Vorteil gegenüber der Verwendung eines Eximer-Lasers. Wird das Target in geringer, vorzugsweise 1 bis 3 cm betragender Entfernung hinter der Anode angeordnet, dann begünstigt das einen niederohmigen Plasmakontakt zwischen der Anode und dem Target mit der Folge, dass der Elektronenstrahl räumlich eng begrenzt auf das Target auftrifft und relativ viel Energie im Target deponiert. Ordnet man andererseits das Target in größerer Entfernung von der Anode an, vorzugsweise mehr als 10 cm hinter dem Loch in der Anode, dann hat das den Vorteil einer weitgehend homogenen Energiezufuhr in die Targetoberfläche.

Vorzugsweise sind in der Vorrichtung Mittel zum Erzeugen eines Druckgefälles zwischen der Gasentladungskammer und dem Target vorgesehen. Da der Gasdruck in der Gasentladungskammer in Abstimmung auf deren Abmessungen in der Regel vorgewählt ist und nicht variiert wird, wird das Druckgefälle durch Erhöhen oder Erniedrigen des Drucks im Raum hinter der Anode erzeugt. Ein Grund für ein solches Druckgefälle kann darin liegen, dass in der Umgebung des Substrates ein höherer Sauerstoffpartialdruck erwünscht ist. Es könnte aber auch von Vorteil sein, im Raum hinter der Anode einen geringeren Druck einzustellen als in der eigentlichen Gasentladungskammer, um das Eindringen von verdampftem Targetmaterial in die Gasentladungskammer zu unterbinden. Bei vorgegebener Pumpleistung kann ein Druckgefälle durch geeignete geometrische Bemessung der Pumpleitungen und Pumpleitungsquerschnitte und/oder der Verbindungen zwischen der Gasentladungskammer und dem raum hinter der Anode, in welchem sich das Target befindet, ferner auch durch Steuerung der Gaszufuhr eingestellt werden (Ansprüche 27 und 28). Eine Erhöhung des Druckes in dem Bereich zwischen Anode und Target ist besonders dann angezeigt, wenn das Target sich in größerer Entfernung von der Anode befindet, denn durch die Druckerhöhung wird die Teilchendichte in dem den Elektronenstrahl umgebenden Plasma und damit die Leitfähigkeit in der den Elektronenstrahl umgebenden Plasmahülle erhöht, so dass der Strahl leichter größere Entfernungen überwinden kann, ohne aufzuplatzen.

Für den Betrieb besonders günstig ist eine Weiterbildung der in der vorliegenden Erfindung verwendeten, Vorrichtung dahingehend, dass Kathode und Anode mit einem wiederaufladbaren, durch eine zwischen Kathode und Anode erfolgende Pseudofunkenentladung entladbaren Energiespeicher verbunden sind, insbesondere mit einem Kondensator oder mit einer Anordnung mehrerer Kondensatoren mit einer Gesamtkapazität von vorzugsweise 100 pF bis zu 20.000 pF. Durch einen solchen, durch die Pseudofunkenentladung entladbaren Energiespeicher läßt sich nicht nur die Energiemenge, die durch ejde Entladung im Target deponiert wird, erhöhen, sondern auch die Energieverteilung der Elektronen im Elektronenstrahl, und zwar insbesondere durch eine Verlängerung der Pseudofunkenentladung, welche normalerweise binnen etwa 20 ns abläuft, bis in den Mikrosekundenbereich hinein. Es hat sich gezeigt, dass nach der Anfangsphase der Pseudofunkenentladung, in welcher vorwiegend hochenergetische Elektronen (typisch im Bereich zwischen 20 und 30 keV) auftreten, in einer späteren Phase der Entladung verstärkt relativ niederenergetische Elektronden (im keV-Bereich) auftreten, welche sich für ein gleichmässiges Verdampfen des Targetmaterials als besonders günstig erwiesen haben. Zugleich kann durch die Wahl der Kapazität des Energiespeichers bei vorgegebener Induktivität der Zuleitungen zu den Elektroden der Gasentladungskammer die Zeit, in der die elektrische Energie für die Entladung bereitgestellt wird, beeinflußt werden. Wegen der hohen Dielektrizitätkonstanten von Wasser eignen sich als Energiespeicher besonders Kondensatoren mit Wasser als Dielektrikum. Zwischen dem Energiespeicher und den Elektroden der Gasentladungskammer sieht man am besten einen schnellen elektronischen Schalter vor, der im selben Takt wie die Pseudofunkenentladung getriggert wird. Auf diese Weise ist ein optimaler Energieeintrag möglich.

Ähnlich wie beim gaselektronischen Schalter, der in der Patentanmeldung PCT/EP88/00 574 beschrieben ist, ist es zweckmässig, Maßnahmen zu ergreifen, um den Niederschlag von freigesetztem Elektrodenmaterial auf den isolierenden Wänden zu verhindern, sei es durch Umwege für Gleitentladungen der Wände der Gasentladungskammer, sei es durch Schirme auf den Elektroden. Ebenso wie beim gaselektronischen Schalter kann es auch für die vorliegende Erfindung von Vorteil sein, zwischen Kathode und Anode weitere Zwischeneletroden vorzusehen, die entweder über Spannungsteiler ein definiertes Potential erhalten oder freiflutend angeordnet sein können. Die Zündung der Pseudofunkenentladung kann durch Injektion eines Plasmas aus einer im Kathodenhinterraum dauernd brennden Glimmentladung oder durch Gleitfunken an der Kathode oder an der Anode getriggert werden. Insoweit wird auf die Ausführungen in der Anmeldung PCT/EP 88/00 574 verwiesen.

Ausführungsbeispiele der in der vorliegenden Erfindung verwendeten Vorrichtung sind schematisch in den beigefügten Zeichnungen dargestellt.
- Figur 1: zeigt schematisch eine Pseudofunken-Gasentladungskammer mit den zugehörigen Elektroden im Längsschnitt,
- Figur 2: zeigt schematisch ein anderes Ausführungsbeispiel einer Pseudofunken-Gasentladungskammer im Längsschnitt,
- Figur 3: zeigt schematisch ein Ausführungsbeispiel einer Beschichtungskammer im Bereich hinter der Anode einer Pseudofunken-Gasentladungskammer im Längsschnitt,
- Figur 4: zeigt schematisch den Gesamtaufbau einer Vorrichtung zum Beschichten von Substraten unter Verwendung einer Pseudofunken-Gasentladung,
- Figur 5: zeigt schematisch als Detail die Anordnung einer Blende hinter der Anode der Gasentladungskammer,
- Figur 6: zeigt schematisch eine Gasentladungskammer, in welcher Anode und Kathode metallische Schirme tragen, und
- Figur 7: zeigt ein Detail einer Gasentladungskammer mit Zwischenelektroden zwischen Anode und Kathode, wobei alle Elektroden metallische Schirme tragen.

In den verschiedenen Ausführungsbeispielen der in der vorliegenden Erfindung verwendeten Vorrichtung sind gleiche oder einander entsprechende Teile mit übereinstimmenden Bezugszahlen bezeichnet.

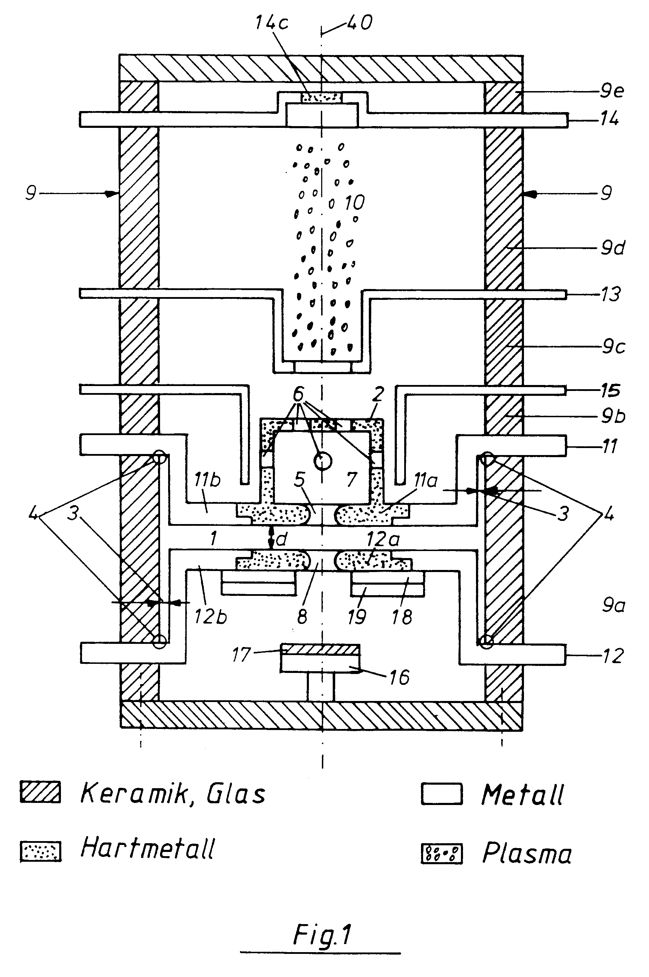

Figur 1 zeigt den Aufbau eines im wesentlichen zylindrischen Entladungsgefäßes, dessen elektrisch isolierende Wand 9 hintereinander aus mehreren Abschnitten 9a, 9b, 9c, 9d und 9e besteht. In diesem Gefäß, welches eine Gasentladungskammer begrenzt, befinden sich hintereinander eine Anode 12, eine Kathode 11, ein metallischer Schirm 15 und zwei Hilfselektroden 13 und 14, welche durch die verschiedenen Abschnitte der isolierenden Wand voneinander getrennt und gasdicht mit ihr verbunden sind. Die Wand 9 besteht aus Glas oder einem keramischen Werkstoff. Die Kathode 11 und die Anode 12 sind parallel zueinander im Abstand d angeordnet. In der Mitte der Kathode 11 befindet sich ein Loch 5 und diesem gegenüberliegend befindet sich in der Anode 12 ein weiteres Loch 8. Die Flucht der beiden Löcher 5 und 8 definiert einen Gasentladungskanal, in welchem bei passend eingestelltem Gasdruck eine Pseudofunken-Gasentladung stattfinden kann.

Auf der Rückseite der Kathode 11 ist ein Metallkäfig 2 vorgesehen, dessen Hohlraum 7 durch Öffnungen 6 mit dem Kathoden-Hinterraum und durch das Loch 5 mit dem Raum 1 zwischen Kathode 11 und Anode 12 in Verbindung steht.

Das ganze System ist rotationssymmetrisch, wobei die Symmetrieachse 40 zugleich die Achse der zwei Löcher 5 und 8 in der Mitte der Kathode 11 bzw. der Anode 12 ist. Im Umgebungsbereich 11a bzw. 12a der Löcher 5 und 8 sind die Kathode 11 und die Anode 12 eben ausgebildet und bestehen aus einem Hartmetall, welches die durch das Auftreffen von Ladungsträgern besonders beanspruchten Elektrodenteile widerstandsfähig machen soll. Im Aussenbereich 11b bzw. 12b bestehen die Kathode und die Anode aus Kupfer oder aus einer Legierung mit niedrigerem, an den Wärmeausdehnungskoeffizienten der Wand 9 angenäherten Wärmeausdehungskoeffizienten als Kupfer, z.B. aus COVAR. Nahe beim Abschnitt 9a der Wand 9 springen jedoch die Anode und die Kathode unter Bildung eines engen Ringspalts 3 zurück und führen erst in einigem Abstand von der Vorderseite der Elektroden aus der Gasentladungskammer heraus. Im Ringspalt 3 steht das elektrische Feld bei anliegender Spannung an Kathode 11 und Anode 12 fast senkrecht auf den der Wand 9 zugewandten Oberflächen der Elektroden. Dies läßt sich bei einem engen Raumgebiet, wo der Ringspalt 3 schmaler ist als der im Lochbereich gemessene Abstand d zwischen Anode 12 und Kathode 11 erreichen, da dann das elektrische Feld beim Eindringen in den Ringspalt 3 sehr stark reduziert auftritt. Auf diese Weise ist gewährleistet, dass in den Ringspalt 3 hinein praktisch keine Ladungsträgerbeschleunigung erfolgen kann, so dass der kritische Bereich an der Berührungslinie 4 zwischen Metall, Isolator 9a und Gas praktisch im feldfreien Raum verläuft, mithin nicht mehr wesentlicher Ausgangspunkt von Ladungsträgern sein kann. Dies ist wichtig für die Unterdrückung möglicher Gleitentladungen, die bei Anliegen hoher Spannungen im Haltezustand der Pseudofunkenkammer sich sonst auf der Isolator-Oberfläche ausbilden können und die als unerwünschte Durchschläge sonst besonders leicht an diesen tripelpunktartigen Berührungslinien 4 entstehen. Diese für die Langzeitstabilität von Pseudofunkenkammern wichtige Maßnahme wird am besten wirksam, wenn zwischen beiden Hauptelektroden (Kathode 11 und Anode 12) und der isolierenden Wand 9a ein solcher enger Spalt 3 vorgesehen ist, durch den die Elektrodendurchführungen durch die Wand 9 im Vergleich zu planparallelen Elektroden geometrisch zurückversetzt sind.

Die beiden hinter der Kathode 11 vorgesehenen Hilfselektroden 13 und 14 dienen zur Auslösung der Pseudofunken-Gasentladungen. Die der Kathode 11 benachbarte Hilfselektrode 13 ist eine Glimmentladungselektrode, die positiv oder negativ geschaltet ist, also als Kathode oder Anode eines Glimmentladungssystems dienen kann. Von ihr fließt der wesentliche Glimmentladungsstrom zur gegenüberliegenden Hilfselektrode 14, die sich im wesentlichen auf einem Potential ungefähr in Höhe des Potentials der Kathode 11 befindet. Die Hilfselektrode 13 ist in einer solchen räumlichen Lage, dass der Glimmentladungsstrom sich zur Kathode 11 und zur gegenüberliegenden Hilfselektrode 14 verzweigen kann. Vorzugsweise wird die Stromverzweigung so vorgenommen, dass nur ein kleiner Teil des Glimmentladungsstroms in Richtung Kathode 11 fließt. Um einen fluktuationsfreien Ablauf der Pseudofunkenentladung zu erreichen, ist es ratsam, die Stromverzweigung so einzustellen, dass ein nennenswerter Dauerstrom (größenordnungsmässig 10⁻⁷A bis 10⁻⁵A ) in den Bereich des Lochs 5 der Kathode 11 gelangt. Dieser Ladungsträgerstrom, der in das Loch 5 der Kathode 11 gelangt, bewirkt, dass hier ständig ein schwaches Untergrund-Plasma vorhanden ist. Die Pseudofunken-Gasentladung kann dadurch gezündet werden, dass man impulsförmig zusätzliche Ladungsträger in den Hohlraum hinter der Kathode injiziert, beispielsweise dadurch, dass man die Hilfselektroden 13 und 14 mit einer impulsförmig betreibbaren Spannungsquelle verbindet oder indem man weitere Hilfselektroden vorsieht, die im Kathodenhinterraum angeordnet sind und auf die zwischen den Hilfselektroden 13 und 14 brennende Niederdruck-Gasentladung so einwirken, dass die Injektion von Ladungsträgern aus dieser Niederdruck-Gasentladung in den Hohlraum 7 hinter der Kathode 11 zur Zündung des Pseudofunkens impulsartig verstärkt wird. Eine andere Möglichkeit zur impulsförmigen Verstärkung des Plasmas im Raum 7 hinter der Kathode besteht darin, den Raum 7 zu beleuchten und durch gezielte fotoelektrische Wechselwirkung zusätzliche Ladungsträger zu erzeugen.

Die Pseudofunken-Gasentladung ist dadurch gekennzeichnet, dass ein Plasmastrahl nach dem Zünden des Pseudofunkens in den hinter der Kathode 11 liegenden Raum läuft und dort unerwünschterweise die Wand 9 beleuchtet und durch Fotoeffekt und durch Sputterprozesse Elektrodenmaterial in die Gasphase transportiert, so dass Maßnahmen ratsam sind, um die Diffusion des Elektrodenmaterials an die Isolatorwand 9 zu behindern. Dem dient der Schirm 15, welcher einen Teil der Öffnung des Kathodenkäfigs 2 abschirmt, und die Glimmentladungselektrode 13 ist so gestaltet, dass sie ebenfalls zur Abschirmung der Öffnungen 6 des Kathodenkäfigs 2 beiträgt.

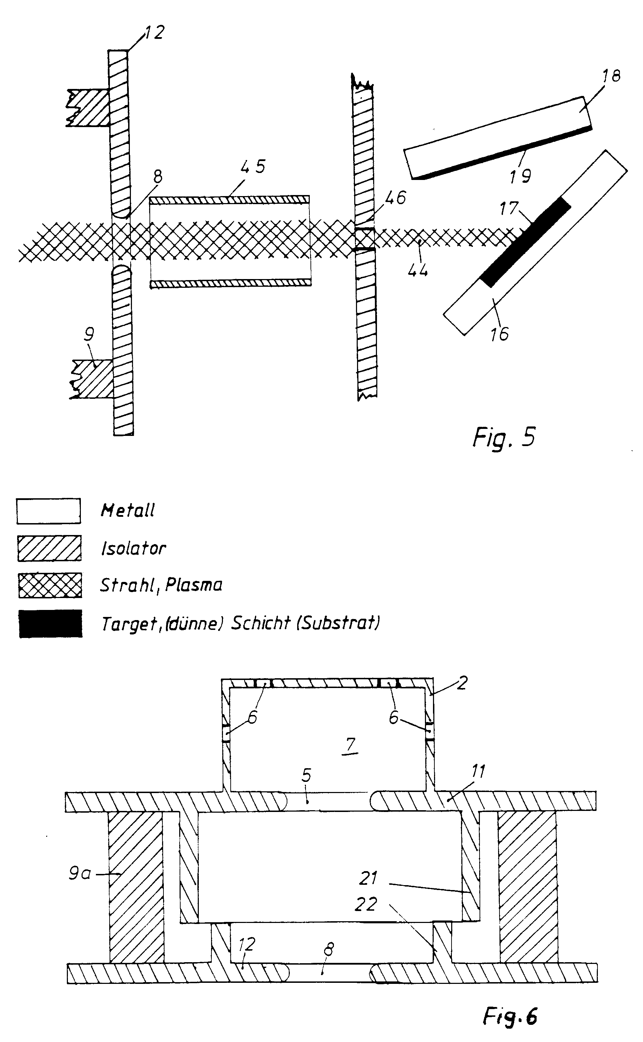

In ähnlicher Weise sind bei dem in Figur 6 dargestellten Ausführungsbeispiel die Kathode 11 und die Anode 12 so gestaltet, dass die zwischen ihnen ablaufende Pseudofunkenentladung den Abschnitt 9a der Wand nicht direkt beleuchten kann. Zu diesem Zweck hat die Kathode 11 einen zur Wand 9a parallelen ringförmigen Fortsatz 21 und die Anode einen entsprechenden ringförmigen Fortsatz 22, die gemeinsam die Wand 9a abschirmen.

Der Raum 23 hinter der Anode ist als Beschichtungskammer ausgebildet. Er enthält dem Loch in der Anode gegenüberliegend eine Halterung 16 für ein Target 17 und eine oder mehrere Halterungen 18 für zu beschichtende Substrate 19, welche im Beispiel gemäß Fig. 1 an der Rückseite der Anode 12 angeordnet sind. Der die Pseudofunken-Gasentladung begleitende Elektronenstrahl tritt durch das Loch 8 in die Beschichtungskammer 23 ein, trifft dort auf das Target 17 und verdampft einen Teil des Targets, welcher sich auf den Substraten 19 niederschlägt.

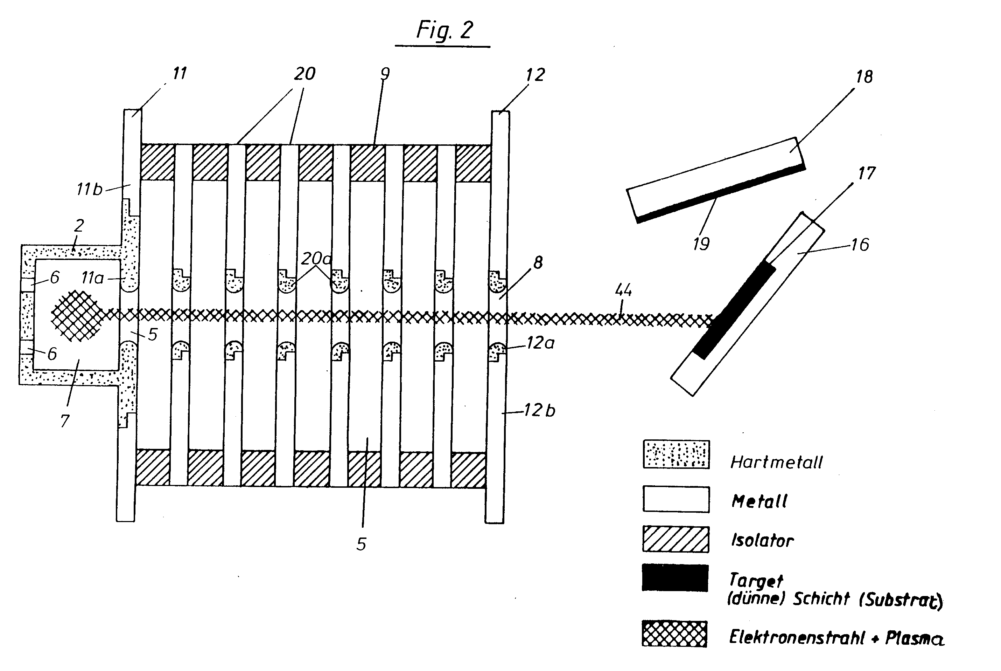

Vorzugsweise sind zwischen Kathode 11 und Anode 12 noch Zwischenelektroden 20 vorgesehen, die ebenfalls in der Mitte jeweils ein mit den Löchern 5 und 8 in der Kathode und Anode fluchtende Löcher haben, deren Rand jeweils mit einem Hartmetallring 20a bestückt ist. Diese Zwischenelektroden 20 erhöhen einerseits die Spannungsfestigkeit der Gasentladungskammer und haben andererseits einen günstigen Einfluß auf die Bildung eines Elektronenstrahls 44, der zusammen mit der ihn umgebenden Plasmahülle in Fig. 2 angedeutet ist. Er nimmt seinen Ausgang von einer Ladungsträgerwolke im Innern des Kathodenkäfigs 2 und führt geradlinig durch den Kanal, der durch die zentralen Löcher in den Elektroden 11, 12 und 20 begrenzt wird, zum hinter der Anode 12 liegenden Target 17. Die Zwischenelektroden 20 können definierte Potentiale haben, die zwischen dem Kathodenpotential und Anodenpotential liegen und beispielsweise mittels eines Spannungsteiles von der Spannung zwischen Kathode und Anode abgeleitet werden. Vorzugsweise sind die Zwischenelektroden 20 jedoch frei flutend angeordnet. Ähnlich wie das für die Kathode 11 und Anode 12 im Ausführungsbeispiel gemäß Fig. 6 gilt, kann es von Vorteil sein, die Zwischenelektroden mit koaxial angeordneten, ringförmigen Metallschirmen 24 zu versehen, um die Wand 9 des Entladungsgefäßes vor einem Niederschlag von abgetragenem Elektrodenmaterial zu schützen. Eine derartige Ausbildung ist im Ausführungsbeispiel gemäß Fig. 7 dargestellt. In diesem Ausführungsbeispiel ist die Wand 9 des Entladungsgefäßes zwischen den Zwischenelektroden 20 zusätzlich mit ringförmigen Vorsprüngen 25 versehen, welche radial einwärts vorspringen und den Weg zwischen zwei benachbarten Elektroden 20 entlang der Oberfläche der isolierenden Wand 9 verlängern, wobei der Abstand zwischen den Zwischenelektroden 20 und den Fortsätzen 25 kleiner gehalten wird als der Elektrodenabstand im Lochbereich.

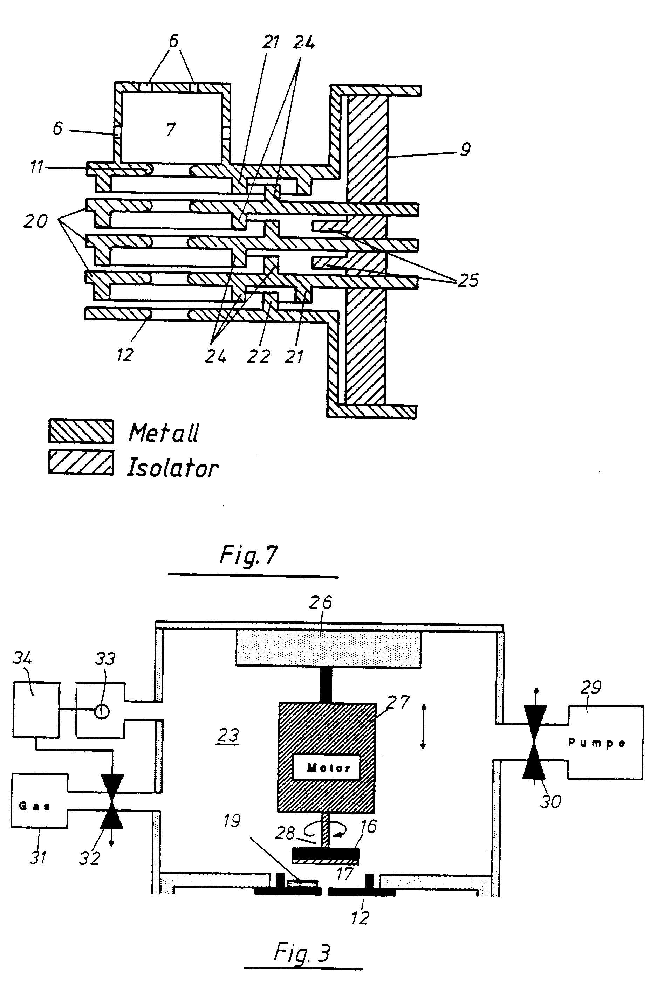

Damit der Elektronenstrahl nicht immer auf dieselbe Stelle des Targets 17 trifft, ist die Halterung 16 für das Target vorzugsweise beweglich gelagert. Figur 3 zeigt ein solches Ausführungsbeispiel einer Beschichtungsvorrichtung, von welcher im wesentlichen nur die Beschichtungskammer 23, nicht aber die Gasentladungskammer dargestellt ist. An der Rückwand der Gasentladungskammer befindet sich ein Sockel 26, an welchem abstandsveränderlich ein Motor 27 angebracht ist, dessen Welle 28 die Halterung 16 für das Target trägt. Auf diese Weise kann einerseits der Abstand des Targets 17 von der Anode 12 verändert und andererseits das Target 17 gedreht werden. Das zu beschichtende Substrat 19 ist an der Rückseite der Anode 12 angebracht. In Fig. 3 ist darüberhinaus schematisch gezeigt, dass zum Abpumpen der Beschichtungskammer 23 eine Pumpe 29 vorgesehen ist, die durch ein steuerbares Ventil 30 strömungsmässig von der Beschichtungskammer 23 getrennt werden kann. Ausserdem ist die Beschichtungskammer mit einem Vorratsbehälter 31 für ein Inertgas und/oder ein Reaktivgas verbunden. Damit dieses Gas dosiert in die Beschichtungskammer 23 eingeleitet werden kann, ist in der Verbindungsleitung zwischen dem Vorratsbehälter 31 und der Beschichtungskammer 23 ein Regulierventil 32 vorgesehen. Zur Überwachung des Gasdrucks in der Beschichtungskammer ist ein Drucksensor 33 vorgesehen. Ferner ist ein Regelgerät 34 vorgesehen, das mit dem Sensor 33 und dem Regulierventil 32 in einer Regelschleife liegt und es gestattet, den Druck in der Beschichtungskammer auf einen vorgegebenen konstanten Wert oder nach einem vorgegebenen Programm zu regeln.

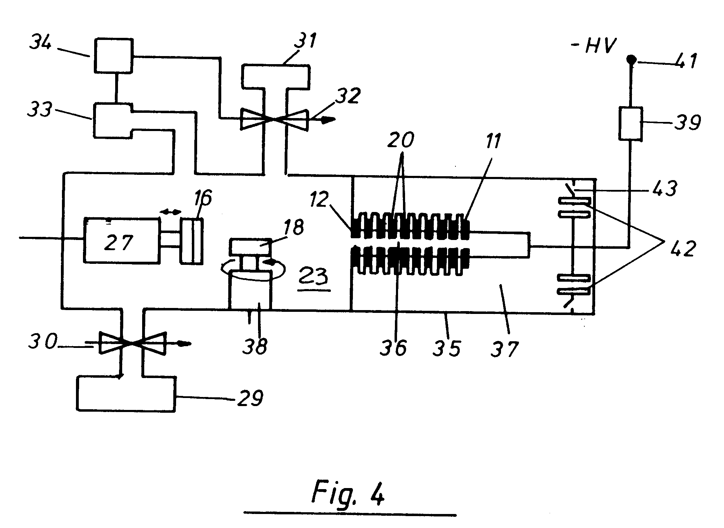

Figur 4 zeigt eine gesamte Beschichtungsvorrichtung in einer Blockdarstellung. Die Vorrichtung hat ein Gehäuse 35, dessen Innenraum im wesentlichen in drei Kammern unterteilt ist, nämlich in die eigentliche Gasentladungskammer 36, in die Beschichtungskammer 23, welche mit der Gasentladungskammer 36 über das Loch in der Anode 12 in Verbindung steht, und eine von der Beschichtungskammer 23 getrennte, die Gasentladungskammer 36 umgebende Kammer 37, welche evakuiert oder mit einem hochspannungsfesten Transformatorenöl gefüllt ist. Die Beschichtungskammer 23 kann wie in Fig. 3 dargestellt abgepumpt, mit einem Gas gefüllt und unter einem vorgegebenen niederen Druck gehalten werden. In der Beschichtungskammer 23 befindet sich ein Motor 27, welcher die Halterung 16 für das Target in vorwählbarem Abstand von der Anode 12 positionieren und verdrehen kann. Statt einer Verdrehung der Halterung 16 für das Target könnte man auch einen Antrieb für eine Bewegung der Halterung 16 in zwei zueinander senkrechten und senkrecht zur Längsachse der Gasentladungskammer 36 verlaufenden Richtungen vorsehen. Seitlich zwischen der Halterung 16 für das Target und der Anode 12 ist eine durch einen Motor 38 bewegbare Halterung 18 für ein Substrat vorgesehen.

Die Gasentladungskammer 36 wird in der schon beschriebenen Weise durch eine Kathode 11, eine Anode 12 und eine Anzahl Zwischenelektroden 20 gebildet, welche durch eine elektrisch isolierende, zylindrische Wand miteinander verbunden sind. Die Kathode 11 ist über einen Vorwiderstand 39 mit dem negativen Pol einer Hochspannungsquelle 41 verbunden. Zwischen Kathode 11 und Anode 13 sind ferner Kondensatoren 42 vorgesehen, welche durch die Pseudofunken-Gasentladung entladen werden. Die Kondensatoren 42 sind mitbestimmend für die Dauer, den Verlauf und den Energieinhalt des Pseudofunkens. Die Entladung der Kondensatoren erfolgt vorzugsweise über einen schnellen elektronischen Schalter 43 zwischen den Kondensatoren und den Elektroden.

Die Energieverteilung der Elektronen im Elektronenstrahl 44 kann auf elektrischem Wege, aber auch mechanisch durch Ausblenden von Teilbereichen des Elektronenstrahls beeinflußt werden. Eine Blende 46 für diesen Zweck zeigt Fig. 5. Die Blende 46 liegt zwischen der Anode 12 und dem Target 17. Zwischen der Blende 46 und der Anode 12 ist noch ein metallisches Rohr 45 vorgesehen, welches den Elektronenstrahl 44 umgibt. Das Rohr 45 und die Blende 46 sind mit der Anode elektrisch verbunden und befinden sich auf demselben Potential.

## Patentansprüche

1. Verfahren zum Erzeugen dünner Schichten aus hochschmelzendem oder bei hoher Temperatur sublimierendem Material auf einem Substrat durch Verdampfen des Materials durch gepulstes Bestrahlen eines das Material enthaltenden Targets und Niederschlagen des verdampften Materials auf dem Substrat,
dadurch gekennzeichnet, dass das Material aus unterschiedlichen chemischen Komponenten zusammengesetzt ist, und das Target mit einem Elektronenstrahl bestrahlt wird, der durch eine ihn umgebende Raumladungshülle eingeschnürt wird und das Material nicht nur verdampft, sondern in einen Plasmazustand überführt,
und dass der Elektronenstrahl durch eine Pseudofunken-Gasentladung gepulst erzeugt wird.

2. Verfahren nach Anspruch 1, dadurch gekennzeichnet, dass das Target aus elektrisch halbleitendem oder nichtleitendem Material oder aus einem Gemisch oder Verbund solcher Materialien besteht.

3. Verfahren nach Anspruch 1 oder 2, dadurch gekennzeichnet, dass das Target aus keramischem Material oder aus einem oder mehreren Metalloxiden oder aus Gemischen davon besteht.

4. Verfahren nach Anspruch 3, dadurch gekennzeichnet, daß dünne Schichten aus einem Hochtemperatur-Supraleiter erzeugt werden.

5. Verfahren nach Anspruch 4, dadurch gekennzeichnet, dass das die Komponenten des Hochtemperatur-Supraleiters gemeinsam in einem Target vorgesehen sind.

6. Verfahren nach Anspruch 5, dadurch gekennzeichnet, dass die Komponenten des Hochtemperatur-Supraleiters im Target in dem stöchiometrischen Verhältnis, bei welchem Supraleitung auftritt, enthalten sind.

7. Verfahren nach Anspruch 4, 5 oder 6, dadurch gekennzeichnet, daß Hochtemperatur-Supraleiter vom Typ Y-Ba-Cu-O, insbesondere Y₁Ba₂Cu₃O₇ hergestellt werden.

8. Verfahren nach einem der vorstehenden Ansprüche, dadurch gekennzeichnet, dass man den Brennfleck des Elektronenstrahls über das Target wandern läßt.

9. Verfahren nach einem der vorhergehenden Ansprüche, dadurch gekennzeichnet, dass man die Lage des Substrats während des Beschichtungsvorgangs ändert.

10. Verfahren nach einem der vorhergehenden Ansprüche, dadurch gekennzeichnet, dass das Substrat beheizt wird.

11. Verfahren nach Anspruch 7 und 10, dadurch gekennzeichnet, dass das Substrat auf eine Temperatur von wenigstens 880°C aufgeheizt wird.

12. Verfahren nach einem der Ansprüche 1 bis 9, dadurch gekennzeichnet, dass das Substrat gekühlt wird.

13. Verfahren nach einem der vorstehenden Ansprüche, dadurch gekennzeichnet, dass dann, wenn oxidische oder oxidkeramische Schichten erzeugt werden, in Sauerstoff enthaltender Atmosphäre gearbeitet wird.

14. Verfahren nach einem der vorstehenden Ansprüche, dadurch gekennzeichnet, dass zur Beeinflussung der Energieverteilung der auf das Target auftreffenden Elektronen Teilbereiche des Elektronenstrahls ausgeblendet werden.

15. Verfahren nach einem der vorstehenden Ansprüche, dadurch gekennzeichnet, dass zum Verdampfen des Materials von einem oder mehreren Targets mehrere Elektronenstrahlen nebeneinander verwendet werden.

16. Verfahren nach einem der vorstehenden Ansprüche, dadurch gekennzeichnet, dass die erzeugten dünnen Schichten zur Optimierung ihrer Zusammensetzung und/oder ihrer Struktur einer physikalischen und/oder chemischen Nachbehandlung unterzogen werden.

17. Verfahren nach Anspruch 16, dadurch gekennzeichnet, dass die Schichten getempert werden.

18. Verfahren nach Anspruch 17, dadurch gekennzeichnet, dass dann, wenn oxidische oder oxidkeramische Schichten erzeugt werden die Wärmebehandlung in Sauerstoff enthaltender Atmosphäre erfolgt.

19. Verfahren nach Anspruch 16, dadurch gekennzeichnet, dass man die Schichten einer Wechselwirkung mit einem Plasma aussetzt.

20. Verfahren nach Anspruch 16, dadurch gekennzeichnet, dass man die Schichten mit einem Pseudofunken-Elektronenstrahl behandelt.

21. Verwendung einer Vorrichtung zum Erzeugen dünner Schichten aus hochschmelzendem oder bei hoher Temperatur sublimierendem Material, welches aus unterschiedlichen chemischen Komponenten zusammengesetzt ist, nach dem Verfahren gemäss Anspruch 1, wobei das Material durch einen gepulsten Pseudofunken-Elektronenstrahl innerhalb eines Gehäuses (35) Verdampft wird, und die Vorrichtung
eine im Gehäuse (35) ausgebildete Gasentladungskammer (36), in welcher eine Kathode (11) und eine Anode (12) in einem Abstand (d) voneinander angeordnet sind, welche beide ein Loch (5, 8) haben, und
Mittel zum Zünden von Pseudofunkenentladungen in der Gasentladungskammer (36) aufweist,
wobei in dem Bereich (23) des Gehäuses (35), welcher auf der der Kathode (11) abgewandten Seite der Anode (12) liegt, das Material angeordnet wird, und
wobei hinter der Anode (12) eine Halterung (16) für ein Target (17) aus dem Material und wenigstens eine Halterung (18) für wenigstens ein zu beschichtendes Substrat (19) vorgesehen wird, das Gehäuse (35) einen verschließbaren Zugang hat, und eine Pumpe (29) zum Abpumpen von Gas aus dem Gehäuse (35) vorgesehen ist.

22. Verwendung nach Anspruch 21, dadurch gekennzeichnet, dass die Löcher (5, 8) in Anode (12) und Kathode (11) miteinander fluchten.

23. Verwendung nach Anspruch 21 oder 22, dadurch gekennzeichnet, dass das Target (17) hinter dem Loch (8) in der Anode (12) angeordnet wird, vorzugsweise in der Flucht der Löcher (5, 8) in Anode (12) und Kathode (11).

24. Verwendung nach Anspruch 21, dadurch gekennzeichnet, dass Mittel (8,29,30,32,46) vorgesehen werden, durch die ein Druckgefälle zwischen der Gasentladungskammer (36) und dem Target (17) erzeugt wird.

25. Verwendung nach Anspruch 24, dadurch gekennzeichnet, dass zwischen dem Loch (8) in der Anode (12) und dem Target (17) ein oder mehrere Kanäle (45) vorgesehen werden.

26. Verwendung nach Anspruch 21, dadurch gekennzeichnet, dass die Halterung (18) für das Substrat (19) motorisch bewegbar angeordnet ist.

27. Verwendung nach Anspruch 21, dadurch gekennzeichnet, dass das Substrat (19) durch eine Heizeinrichtung beheizt wird.

28. Verwendung nach Anspruch 21, dadurch gekennzeichnet, dass mehrere Elektronenstrahlen in mehreren, im Gehäuse (35) angeordneten Gasentladungskammern (36) erzeugt werden.

29. Verwendung nach Anspruch 28, dadurch gekennzeichnet, dass im Gehäuse (35) mehrere Targets (17) angeordnet werden.

30. Verwendung nach Anspruch 21, dadurch gekennzeichnet, dass Kathode (11) und Anode (12) mit einem wiederaufladbaren, durch eine zwischen Kathode (11) und Anode (12) erfolgende Pseudofunkenentladung entladbaren Energiespeicher verbunden werden, insbesondere mit einem Kondensator oder mit einer Anordnung mehrerer Kondensatoren (42) mit einer Gesamtkapazität von vorzugsweise 100 pF bis zu 20 000 pF.

31. Verwendung nach Anspruch 30, dadurch gekennzeichnet, dass zwischen dem Energiespeicher ( 42) und den Elektroden (11,12) der Gasentladungskammer ein schneller elektronischer Schalter (43) vorgesehen wird.

32. Verwendung nach Anspruch 35, dadurch gekennzeichnet, dass die als Energiespeicher eingesetzten Kondensatoren (42) als Dielektrikum Wasser enthalten.

## Claims

1. Process for producing thin layers of a material which melts or sublimes at high temperature on a substrate by pulsed irradiation of a target which contains said material, thereby evaporating said material and depositing said evaporated material on said substrate,
characterized in that said material is composed of different chemical constituents, that said target is irradiated by an electron beam which is constricted by a space charge envelope surrounding the electron beam and which is not only evaporating said material but converts the material into a plasma state,
and that the electron beam is a pulsed beam generated by a pseudo-spark gas discharge.

2. A process according to claim 1, characterized in that the target consists of electrically semiconductive or non-conductive material or of a mixture or composite of such materials.

3. A process according to claim 1 or 2, characterized in that the target consists of a ceramic material or of one or a plurality of metal oxides or of mixtures thereof.

4. A process according to claim 3, characterized in that thin layers are produced consisting of a high-temperature supraconductor.

5. A process according to claim 4, characterized in that the constituents of the high-temperature supraconductor are jointly provided in a target.

6. A process according to claim 5, characterized in that the constituents of the high-temperature supraconductor are contained in the target in such stoichiometric proportions that supraconduction will occur.

7. A process according to claim 4, 5 or 6, characterized in that high-temperature supraconductors of the type Y-Ba-Cu-O, particularly Y₁Ba₂Cu₃O₇ are produced.

8. A process according to any of the preceding claims, characterized in that the focal spot of the electron beam is caused to migrate over the target.

9. A process according to any of the preceding claims, characterized in that the position of the substrate is changed during the coating operation.

10. A process according to any of the preceding claims, characterized in that the substrate is heated.

11. A process according to claims 7 and 10, characterized in that the substrate is heated to a temperature of at least 880° C.

12. A process according to any of claims 1 to 9, characterized in that the substrate is cooled.

13. A process according to any of the preceding claims, characterized in that if oxide or ceramic oxide layers are produced, then the process is performed in an oxygen-containing atmosphere.

14. A process according to any of the preceding claims, characterized in that portions of the electron beam are stopped off in order to influence the energy distribution of the electrons impinging on the target.

15. A process according to any of the preceding claims, characterized in that a plurality of juxtaposed electron beams are used to evaporate the material from one or a plurality of targets.

16. A process according to any of the preceding claims, characterized in that the thin layers which are produced are subjected to a physical and/or chemical aftertreatment in order to optimize their composition and/or their structure.

17. A process according to claim 16, characterized in that the layers are annealed.

18. A process according to claim 17, characterized in that if oxide or ceramic oxide layers are produced then the heat-treatment is performed in an oxygen-containing atmosphere.

19. A process according to claim 16, characterized in that the layers are subjected to an interaction which a plasma.

20. A process according to claim 16, characterized in that the layers are treated with a pseudospark electron beam.

21. The use of an apparatus for producing on a substrate of thin layers of a material which is composed of different chemical constituents and which is high-melting or which sublimates at a high temperature in accordance with a process as claimed in claim 1, wherein the material is evaporated in a housing by a pulsed pseudo-spark electron beam, the apparatus comprising
a gas discharge chamber (36) formed in said housing (35), which contains a cathode (11) and an anode (12), which are spaced a distance (d) apart and both of which have a hole (5, 8),
and means for striking pseudospark discharges in the gas discharge chamber (36),
wherein in that region (23) of the housing (35) which is disposed on that side of the anode (12) which faces away from the cathode (11), there is provided said material, and wherein behind said anode (12) there are provided a holder (16) for a target (17) made of said material and at least one substrate to be coated,
the housing (35) has an entrance which is adapted to be closed, and a pump (29) for pumping gas from the housing (35).

22. A use according to claim 21, characterized in that the holes (5, 8) in the anode (12) and cathode (11) are aligned with each other.

23. A use according to claim 21 or 22, characterized in that the target (17) is disposed behind the hole (8) in the anode (12), preferably in alignment with the holes (5, 8) in the anode (12) and cathode (11).

24. A use according to claim 21, characterized in that means (8, 29, 30, 32, 46) are provided for establishing a pressure drop between the gas discharge chamber (36) and the target (17).

25. A use according to claim 24, characterized in that one or a plurality of passages (45) are provided between the hole (8) in the anode (12) and the target (17).

26. A use according to claim 21, characterized in that the holder (18) for the substrate (19) is movable by motor means.

27. A use according to claim 21, characterized in that the substrate (19) is heated by a heating means.

28. A use according to claim 21, characterized in that a plurality of electron beams are generated in a plurality of gas discharge chambers (36) arranged in the housing (35).

29. A use according to claim 28, characterized in that a plurality of targets (17) is arranged in the housing (35).

30. A use according to claim 21, characterized in that the cathode (11) and the anode (12) are connected to a rechargeable energy storage device, which is adapted to be discharged by a pseudospark discharge struck between the cathode (11) and anode (12), particularly to a capacitor or a set consisting of a plurality of capacitors (42) having a total capacitance of preferably 100 picofarads to 20,000 picofarads.

31. A use according to claim 30, characterized in that a fast electronic switch (43) is provided between the energy storage device (42) and the electrodes (11, 12) of the gas discharge chamber.

32. A use according to claim 30, characterized in that the capacitors (42) used as an energy storage device contain water as a dielectric.

## Revendications

1. Procédé pour appliquer des couches minces constituées d'un matériau ayant un point de fusion élevé ou de sublimation à une température élevée, sur un substrat par vaporisation dudit matériau grâce à l'exposition d'une cible réalisée en ledit matériau à un rayonnement pulsé et par déposition du matériau vaporisé sur ledit substrat,
**caractérise en ce que** le matériau comprend plusieurs composants chimiques, en ce que la cible est soumise au rayonnement d'un faisceau électronique pris dans un étranglement par une enveloppe de charge spatiale entourant ledit faisceau et transformant ledit matériau non seulement en vapeur, mais également en plasma,
et en ce que le faisceau électronique est généré par une décharge pulsée de gaz à pseudo-étincelles.

2. Procédé selon la revendication 1, caractérisé en ce que le matériau de la cible est soit un semi-conducteur, soit un non-conducteur électrique, soit un mélange ou un produit composite de matériaux de ce type.

3. Procédé selon la revendication 1 ou 2, caractérisé en ce que le matériau de la cible est soit un matériau céramique, soit un ou plusieurs oxydes métalliques, soit un mélange de matériaux de ce type.

4. Procédé selon la revendication 3, caractérisé en ce que des couches minces sont réalisées grâce à un supra-conducteur à haute température.

5. Procédé selon la revendication 4, caractérisé en ce que tous les composants du supra-conducteur à haute température sont réunis dans une cible.

6. Procédé selon la revendication 5, caractérisé en ce que les composants du supra-conducteur à haute température de la cible sont constitués en des proportions stoechiométriques permettant de produire l'effet de supra-conduction.

7. Procédé selon l'une quelconque des revendications 4, 5 ou 6, caractérisé en ce qu'il consiste à réaliser des supra-conducteurs à haute température du type Y-Ba-Cu-O, plus particulièrement du type Y₁Ba₂Cu₃O₇.

8. Procédé selon l'une quelconque des revendications précédentes, caractérisé en ce que le foyer du faisceau électronique passe progressivement sur la cible.

9. Procédé selon l'une quelconque des revendications précédentes, caractérisé en ce que la position du substrat est modifiée pendant l'application de la couche mince.

10. Procédé selon l'une quelconque des revendications précédentes, caractérisé en ce que le substrat est chauffé.

11. Procédé selon les revendications 7 et 10, caractérisé en ce que le substrat est chauffé à une température d'au moins 880 °C.

12. Procédé selon l'une quelconque des revendications 1 à 9, caractérisé en ce que le substrat est refroidi.

13. Procédé selon l'une quelconque des revendications précédentes, caractérisé en ce que l'opération est effectuée sous une atmosphère d'oxygène lorsque les couches minces appliquées sont des couches d'oxyde ou des couches en céramique oxydée.

14. Procédé selon l'une quelconque des revendications précédentes, caractérisé en ce que certaines zones partielles du faisceau électronique sont masquées pour influencer la répartition de l'énergie des électrons dirigés sur la cible.

15. Procédé selon l'une quelconque des revendications précédentes, caractérisé en ce que la vaporisation du matériau d'une ou de plusieurs cibles est réalisée par plusieurs faisceaux électroniques adjacents.

16. Procédé selon l'une quelconque des revendications précédentes, caractérisé en ce que les couches minces réalisées sont soumises à un traitement physique et/ou chimique ultérieur pour optimiser leur composition et/ou leur structure.

17. Procédé selon la revendication 16, caractérisé en ce que les couches sont rendues malléables.

18. Procédé selon la revendication 17, caractérisé en ce que le traitement thermique est effectué sous une atmosphère d'oxygène lorsque les couches minces appliquées sont des couches oxyde ou des couches en céramique oxydée.

19. Procédé selon la revendication 16, caractérisé en ce que les couches sont exposées à l'effet alternatif d'un plasma.

20. Procédé selon la revendication 16, caractérisé en ce que les couches sont traitées au moyen d'un faisceau électronique à pseudo-étincelles.

21. Utilisation d'un dispositif permettant de réaliser des couches minces constituées d'un matériau ayant un point de fusion élevé ou de sublimation à une température élevée,
ledit matériau, contenant plusieurs composants chimiques, étant vaporisé par un faisceau électronique pulsé à pseudo-étincelles à l'intérieur d'un boîtier (35),
ledit dispositif présentant une chambre (36) de décharge gazeuse dans ledit boîtier (35), ainsi qu'une cathode (11) et une anode (12) munies chacune d'un trou l'énergie des électrons dirigés sur la cible.
(5, 8) et disposées dans ladite chambre (36) avec un écartement (d) entre elles, et
ledit dispositif présentant des moyens pour déclencher des décharges de pseudo-étincelles dans la chambre (36) de décharge gazeuse,
ledit matériau étant disposé dans la zone (23) du boitier (35) situé sur la face de l'anode (12) opposée à la face orientée vers la cathode (11), et
ledit dispositif présentant une fixation (16) pour une cible (17) composée dudit matériau et au moins un moyen de fixation (18) pour au moins un substrat (149) à revêtir étant prévu derrière l'anode (12), l'ouverture d'entrée du boîtier (35) pouvant être obturée et une pompe (29) permettant d'évacuer le gaz du boîtier (35).

22. Utilisation selon la revendication 21, caractérisée en ce que les trous (5, 8) pratiqués dans l'anode (12) et dans la cathode (11) sont alignés l'un par rapport à l'autre.

23. Utilisation selon la revendication 21 ou 22, caractérisée en ce que la cible (17) est disposée derrière le trou (8) prévu dans l'anode (12), de préférence dans l'alignement des trous (5, 8) pratiqués dans l'anode (12) et dans la cathode (11).

24. Utilisation selon la revendication 21, caractérisée en ce que des moyens (8, 29, 30, 32, 46) sont prévus pour générer une dépression entre la chambre (36) de décharge gazeuse et la cible (17).

25. Utilisation selon la revendication 24, caractérisée en ce qu'un ou plusieurs canaux (45) sont prévus entre le trou (8) prévu dans l'anode (12) et la cible (17).

26. Utilisation selon la revendication 21, caractérisée en ce que le moyen de fixation (18) du l'énergie des électrons dirigés sur la cible. substrat (19) est disposé de manière à pouvoir être déplacé par un moteur.

27. Utilisation selon la revendication 21, caractérisée en ce que le substrat (19) est chauffé par un dispositif de chauffage.

28. Utilisation selon la revendication 21, caractérisée en ce que plusieurs faisceaux électroniques sont générés dans plusieurs chambres (36) de décharge gazeuse disposées dans le boîtier (35).

29. Utilisation selon la revendication 28, caractérisée en ce que plusieurs cibles (17) sont disposées dans le boîtier (35).

30. Utilisation selon la revendication 21, caractérisée en ce que la cathode (11) et l'anode (12) sont reliées à une source d'énergie rechargeable pouvant produire une décharge de pseudo-étincelles entre la cathode (11) et l'anode (12), plus particulièrement à un condensateur ou à un groupe de plusieurs condensateurs (42) dont la capacité globale est, de préférence, de 100 pF à 20 000 pF.

31. Utilisation selon la revendication 30, caractérisée en ce qu'un interrupteur (43) électronique rapide est monté entre la source d'énergie (42) et les électrodes (11, 12) de la chambre de décharge gazeuse.

32. Utilisation selon la revendication 30, caractérisée en ce que le conducteur diélectrique des condensateurs (42) utilisés comme source d'énergie est de l'eau.
